(19) **Europäisches Patentamt / European Patent Office / Office européen des brevets**

(11) **EP 4 625 480 A1**

(12) **EUROPEAN PATENT APPLICATION**

(43) Date of publication:
01.10.2025 Bulletin 2025/40

(21) Application number: 24196611.8

(22) Date of filing: 27.08.2024

(51) International Patent Classification (IPC):
*H01L 21/67* (2006.01)    *H01L 21/677* (2006.01)
*H01L 21/687* (2006.01)

(52) Cooperative Patent Classification (CPC):
H01L 21/67265; H01L 21/67766; H01L 21/67781;
H01L 21/68707; H01L 21/68771

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.03.2024 JP 2024050710

(71) Applicant: Kokusai Electric Corporation
Tokyo 101-0045 (JP)

(72) Inventors:
• OTA, Takayuki
  Toyama-shi, Toyama 9392393 (JP)
• ABURATANI, Yukinori
  Toyama-shi, Toyama 9392393 (JP)
• NISHINO, Tatsuya
  Toyama-shi, Toyama 9392393 (JP)

(74) Representative: Bardehle Pagenberg
Partnerschaft mbB
Patentanwälte Rechtsanwälte
Prinzregentenplatz 7
81675 München (DE)

(54) **TRANSFER MACHINE, SUBSTRATE PROCESSING APPARATUS, METHOD OF PROCESSING SUBSTRATE, METHOD OF MANUFACTURING SEMICONDUCTOR DEVICE, AND PROGRAM**

(57) There is provided a technique that includes: (a) at least one end effector configured to be capable of being inserted into a holder configured to accommodate a plurality of substrates in multiple stages without being in contact with the plurality of substrates, and gripping a corresponding substrate of the plurality of substrates respectively; and (b) at least one substrate detector arranged at a predetermined relative position with respect to the at least one end effector and configured to be capable of optically detecting the corresponding substrate in at least one selected from the group of a state in which the at least one end effector is inserted into the holder and a state in which the at least one end effector grips the corresponding substrate.

FIG. 3

**Description**

CROSS-REFERENCE TO RELATED APPLICATION

This application is based upon and claims the benefit of priority from Japanese Patent Application No. 2024-050710, filed on March 27, 2024, the entire contents of which are incorporated herein by reference.

TECHNICAL FIELD

The present disclosure relates to a transfer machine, a substrate processing apparatus, a method of processing a substrate, a method of manufacturing a semiconductor device, and a program.

BACKGROUND

A substrate to be processed is transferred inside a semiconductor manufacturing apparatus by a substrate transfer machine. In the related art, the substrate transfer machine may be provided with multiple stages of substrate transfer plates such that a plurality of substrates to be processed may be transferred at a time, and a substrate detection sensor may be installed for each substrate transfer plate to detect presence or absence of a substrate to be processed on the substrate transfer plate.

In a case where the substrate detection sensor is a transmission type fiber sensor, when a substrate is visually transparent, it may not block a light, which may result in erroneous detection.

SUMMARY

Some embodiments of the present disclosure provide a technique capable of detecting a substrate even in a case where the substrate is transparent.

According to some embodiments of the present disclosure, there is provided a technique that includes: (a) at least one end effector configured to be capable of being inserted into a holder configured to accommodate a plurality of substrates in multiple stages without being in contact with the plurality of substrates, and gripping a corresponding substrate of the plurality of substrates respectively; and (b) at least one substrate detector arranged at a predetermined relative position with respect to the at least one end effector and configured to be capable of optically detecting the corresponding substrate in at least one selected from the group of a state in which the at least one end effector is inserted into the holder and a state in which the at least one end effector grips the corresponding substrate, the at least one substrate detector including: (b 1) a light projector formed in a rod-shape and including a first end configured to emit a reference light from a first optical fiber; (b2) a light receiver formed in a rod-shape and including a second end which substantially faces the first end and is configured to receive the reference light reflected by a rear surface or a front surface of the corresponding substrate, which is transparent, and guide the reference light thus received to a second optical fiber; (b3) a plate extending from a vicinity of the first end to a vicinity of the second end on an opposite side of the corresponding substrate when viewed from the light projector and the light receiver; and (b4) a wall configured to prevent the reference light from being directly incident from the first end on the second end.

BRIEF DESCRIPTION OF DRAWINGS

The accompanying drawings, which are incorporated in and constitute a part of the specification, illustrate embodiments of the present disclosure.

FIG. 1 is a perspective view of a substrate processing apparatus suitably used in some embodiments of the present disclosure.
FIG. 2 is a schematic perspective view of a transfer machine suitably used in some embodiments of the present disclosure, for explaining a transfer to a boat by the transfer machine.
FIG. 3 is a view showing an arrangement of end effectors and a substrate detector suitably used in some embodiments of the present disclosure.
FIG. 4 is a view for explaining an arrangement range of a light receiver of a substrate detector suitably used in some embodiments of the present disclosure.
FIG. 5 is a schematic configuration diagram of a controller of a substrate processing apparatus suitably used in some embodiments of the present disclosure.
FIG. 6 is a flow diagram showing a process of processing a substrate applied in some embodiments of the present disclosure.
FIG. 7 is a cross-sectional view showing a substrate detector in other embodiments of the present disclosure.
FIG. 8 is a perspective view showing a substrate detector in other embodiments of the present disclosure.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

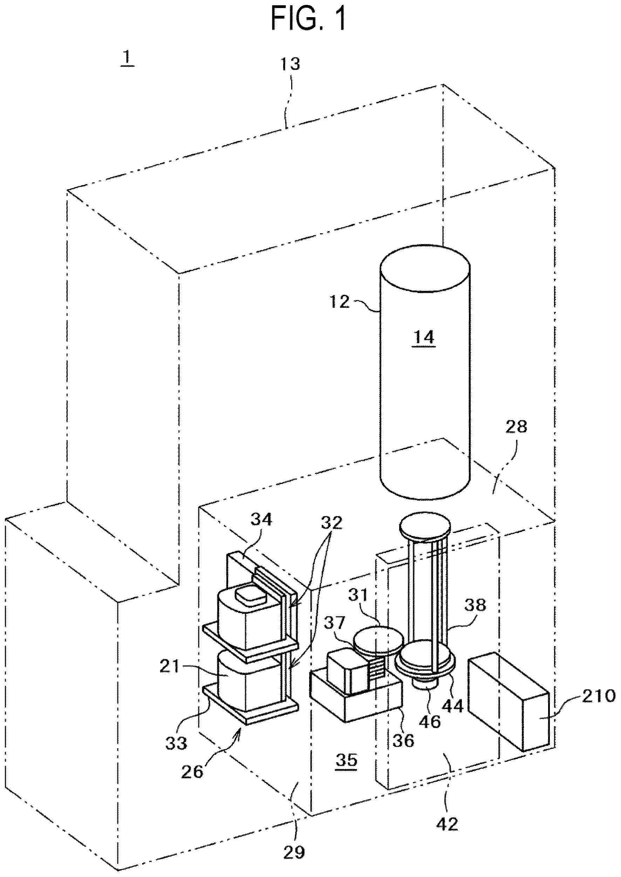

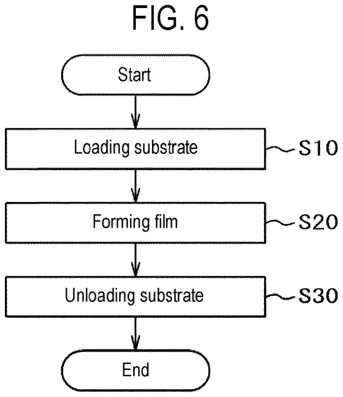

Some embodiments of the present disclosure will now be described mainly with reference to FIGS. 1 to 6. The drawings used in the following description are schematic, and dimensional relationships, ratios, and the like among various components shown in the drawings may not match actual ones. Further, dimensional relationships, ratios, and the like among various components among plural drawings may not match one another. Furthermore, unless otherwise specified herein, each component is not limited to one component, but may be a plurality of components.

(Overview of Substrate Processing Apparatus)

A substrate processing apparatus described in the embodiments of the present disclosure is used in a process of manufacturing a semiconductor device and configured to perform a process (heat treatment) by heating a substrate to be processed with a heater in a state where the substrate is accommodated in a process chamber. More specifically, the substrate processing apparatus of these embodiments is a vertical substrate processing apparatus configured to process a plurality of substrates simultaneously in a state where the substrates are stacked vertically at a predetermined interval.

The substrate to be processed by the substrate processing apparatus may be, for example, a semiconductor wafer substrate (hereinafter, simply referred to as a "wafer") on which a semiconductor device is fabricated. Further, the heat treatment performed by the substrate processing apparatus include, for example, oxidation, diffusion, annealing, reflow, baking, film formation by thermal chemical vapor deposition (CVD) reaction, film quality improvement (treatment), and the like.

(1) Configuration of Substrate Processing Apparatus

An entire apparatus will be described with reference to FIG. 1. FIG. 1 shows main components of a substrate processing apparatus.

The substrate processing apparatus 1 includes a housing 13. A pod (holder) 21, which is a sealed substrate container, is configured to be loaded into the substrate processing apparatus 1 by an in-process transfer apparatus (not shown), and unloaded from the substrate processing apparatus 1.

A sub-housing 28 is installed over a rear end at a lower side of the housing 13 near a rear side of the housing 13 in a front-rear direction. A pair of upper and lower wafer loading and unloading ports 32 configured to load or unload wafers 31 into or from the sub-housing 28 are arranged vertically in two stages at a front wall 29 of the sub-housing 28. Pod openers 26 are installed for the upper and lower wafer loading and unloading ports 32, respectively.

Each of the pod openers 26 includes a mounting stand 33 configured to mount the pod 21 thereon, and an opening/closing mechanism 34 configured to open or close a lid of the pod 21. Each of the pod openers 26 is configured to open or close a wafer entrance of the pod 21 by opening or closing the lid of the pod 21 mounted on the mounting stand 33 by using the opening/closing mechanism 34.

The sub-housing 28 forms a transfer chamber (a loading chamber or a loading area) 35 that is airtight from a space in which the pod openers 26 are disposed. A transfer machine 36 is installed in a front region of the transfer chamber 35. The transfer machine 36 includes a plurality of end effectors 37 configured to hold the wafers 31. Each end effector 37 is capable of moving linearly in the horizontal direction, rotating in the horizontal direction, and moving up or down in a vertical direction. The transfer machine 36 is configured to load or unload the wafers 31 into or from a boat 38 as a substrate holder. Five end effector 37, each of which is also called a substrate gripper, a wafer placement plate, a hand, a chuck, a fork, or a tweezer, are arranged in a direction perpendicular to a surface of each wafer 31 to be gripped.

A vertical process furnace 12 is installed above the transfer chamber 35. The process furnace 12 includes a process chamber 14 formed therein, and a lower end of a furnace opening at a lower side of the process chamber 14 is open and is configured to be opened or closed by a furnace opening shutter (not shown). The process chamber 14 is configured to perform a heat treatment on the wafers 31 held in the boat 38.

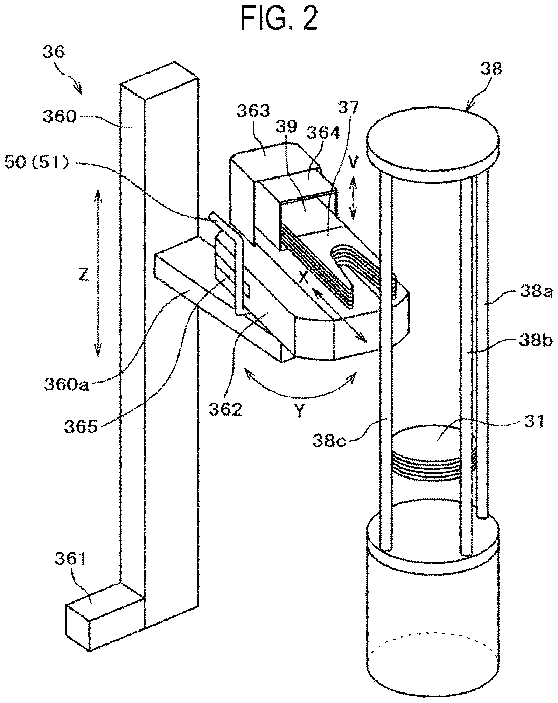

A boat elevator 42 configured to raise or lower the boat 38 is installed at a side surface of the sub-housing 28. A seal cap 44 as a lid is horizontally attached to an elevating stand of the boat elevator 42. The seal cap 44 is configured to be capable of supporting the boat 38 vertically and air-tightly closing the furnace opening in a state where the boat 38 is loaded into the process furnace 12. The transfer chamber 35 is adjacent to the process chamber 14 and configured to load or unload the wafers 31 together with the boat 38 into or from the process chamber 14. The boat 38 is configured to hold a plurality of wafers (for example, 50 to 175 wafers) in such a state that the wafers are arranged in a horizontal posture and in multiple stages at predetermined intervals with centers of the wafers 31 aligned with one another. As shown in FIG. 2, the boat 38 includes posts 38a to 38c as columns configured to hold the wafers 31. The posts 38a to 38c include grooves (slots) formed to hold the wafers 31. An interval between the slots, i.e., an interval between the wafers 31 held in the boat may be normally 6 mm or less, which is different from an interval between the wafers 31 held in the pod 21.

A rotator 46 configured to rotate the boat 38 around a central axis corresponding to the center of the wafers 31 is installed on an opposite side of the seal cap 44 from the process chamber 14. A rotary shaft of the rotator 46 is connected to the boat 38 through the seal cap 44. The rotator 46 is configured to rotate the wafers 31 by rotating the boat 38.

An example of a configuration of the transfer machine will be described with reference to FIG. 2. FIG. 2 shows a state when the transfer machine 36 transfers the wafers 31 to the boat 38. That is, the end effectors 37 of the transfer machine 36 faces the posts 38a and 38c of the boat 38.

The transfer machine 36 includes a guide 360 installed along an up-and-down direction (Z-axis direction), a Z-axis direction driver 361, a Y-axis rotation driver 362, an X-axis direction driver 363, and a V-axis direction driver 364. Each of the drivers 361 to 364 may be referred to as a drive system.

The Z-axis direction driver 361 is installed at a lower end or an upper end of the guide 360 to move a mount 360a in the up-and-down direction (the Z-axis direction or the vertical direction) along the guide 360.

The Y-axis rotation driver 362 is installed on an upper surface of the mount 360a so as to be rotatable in the Y-axis direction such that the Y-axis rotation driver 362 is rotated horizontally clockwise or counterclockwise (around the Y-axis), while supporting the X-axis direction driver 363 so that the X-axis and the Y-axis of the X-axis direction driver 363 are perpendicular to each other. As for a range of the rotation, about 180 degrees is sufficient since the pod 21 is usually positioned between a direction of the boat 38 and its opposite direction when viewed from the Y-axis.

The X-axis direction driver 363 is integrated with or installed inside the Y-axis rotation driver 362 to move the V-axis direction driver 364 forward and backward in the horizontal direction (X-axis direction) while supporting the V-axis direction driver 364. For the X-axis, "forward" is defined as a direction in which the end effectors 37 move to protrude from the Y-axis rotation driver 362 so as to enter the boat 38 or the pod 21.

The V-axis direction driver 364 is installed at the X-axis direction driver 363, and is configured to be capable of supporting five end effectors 37 horizontally and regulating (changing) an interval between the end effectors 37 in the Z-axis direction. Each end effector 37 is mounted on the V-axis direction driver 364 by a corresponding mounter 39. The V-axis direction driver 364 and the mounter 39 constitute a pitch variator.

After being inserted without being in contact with the wafer 31, the end effector 37 may grip the corresponding wafer 31. This allows the transfer machine 36 to use the end effector 37 to discharge the wafer 31 from the pod 21 and load (charge) the same into the boat 38. Then, after any process is performed on the wafer 31 in the process furnace 12, the transfer machine 36 may take out (discharge the wafer 31 from the boat 38 by the end effector 37 and load the same into the pod 21.

The transfer machine 36 further includes a pair of sensor rods 50 installed on both side surfaces of the Y-axis rotation driver 362, and advance and retreat drivers 365 configured to move the sensor rods 50 in the X-axis direction.

The sensor rods 50 extend upward along both side surfaces of the Y-axis rotation driver 362 to substantially the same height as one of the end effectors 37 and are configured to be bent at approximately a right angle in an opposite direction to a mounting direction of the end effector 37 with respect to the X-axis direction driver 363, that is, backward in the X-axis direction. The sensor rods 50 holds a fiber sensor 51 as a mapping sensor.

A light transmitter or a light receiver of the fiber sensor 51 is attached to tips of the pair of sensor rods 50. The fiber sensor 51 is a pair of transmission type sensors, one of which is configured to transmit a light and the other is configured to receive the same, and may be arranged such that a light path (an optical axis) formed between the light transmitter and the light receiver is parallel to a tangent line of the wafer 31. The fiber sensor 51 performs a mapping operation to count the number of wafers 31 loaded in the pod 21 or the boat 38 and detect normality or abnormality such as protrusion of the wafer by detecting interruption of the light path.

The advance and retreat drivers 365 are arranged on both side surfaces of the Y-axis rotation driver 362 and configured to support the sensor rods 50 such that the sensor rods 50 may move between a protruding position and a storage position in the X-axis direction.

The transfer machine 36 is provided with five substrate detectors 60 corresponding to the five end effectors 37. Each substrate detector 60 is arranged at a specific relative position with respect to the corresponding end effector 37. Each substrate detector 60 is configured to be capable of optically detecting the corresponding wafer 31 in at least one selected from the group of a state in which the corresponding end effector 37 is inserted between the wafers 31 held in the boat 38 or the pod 21 and a state in which the end effector 37 grips the corresponding wafer 31.

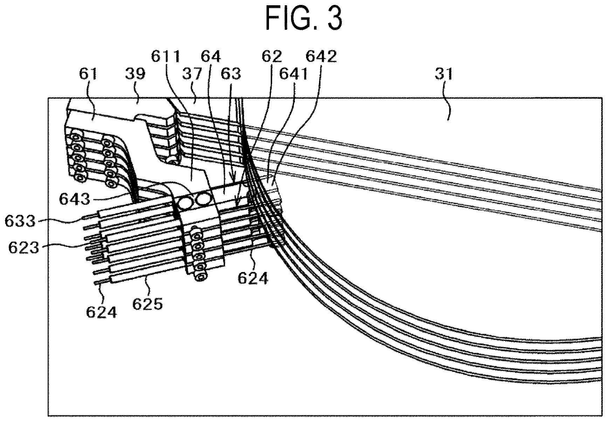

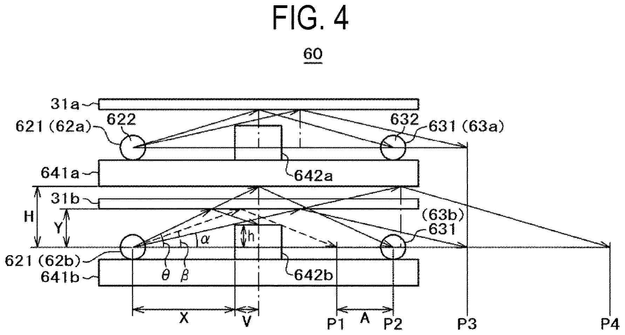

The substrate detector 60 will be described with reference to FIGS. 3 and 4. FIG. 3 shows the state in which the end effector 37 grips the corresponding wafer 31.

The substrate detector 60 includes a support arm 61 as a fixing member, a light projector 62, a light receiver 63, and a partition 64. The substrate detector 60 is a pair of reflective sensors including the light projector 62 and the light receiver 63, which are constituted by fiber sensors. The substrate detector 60 is installed for each end effector 37 separately from the end effector 37.

The support arm 61 is screwed to one side of the mounter 39 of the end effector 37. The support arm 61 extends in parallel to a longitudinal direction of the end effector 37, and bends and extends in a tangential direction of the wafer 31 placed thereon to form a tip 611.

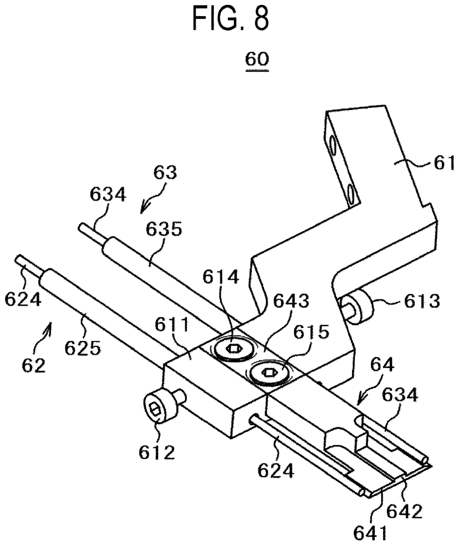

The tip 611 of the support arm 61 is provided with the rod-shaped light projector 62 and light receiver 63. The light projector 62 and the light receiver 63 are each inserted into through-holes formed in the tip 611 and are fixed (screwed) by screws 612 and 613 (see FIG. 8). Further, the light projector 62 and the light receiver 63 are disposed in substantially parallel to each other. Axes (central axes) of the light projector 62 and the light receiver 63 point at substantially the center of the wafer 31 placed on the end effector 37 (substantially coincident with a radial direction). The tips of the light projector 62 and light receiver 63 are located laterally away from a side edge of the end effector 37. Further, the optical axes of the light projector 62 and the light receiver 63 are located inside an outline of the wafer 31 placed on the end effector 37.

The first end 621 of the light projector 62 emits a reference light from a first optical fiber 623. The first end 621 includes a reflector 622 configured to reflect the reference light from the first optical fiber 623 in a direction perpendicular to a longitudinal direction of the light projector 62. This allows the reference light from the first optical fiber 623 to be irradiated to the wafer 31. The second end 631 of the light receiver 63 receives the reference light reflected by a rear surface or a front surface of the wafer 31 and guides the same to a second optical fiber 633. The second end 631 includes a reflector 632 configured to reflect a reference light from a direction perpendicular to a longitudinal direction of the light receiver 63 and guide the same to the second optical fiber 633. This allows the reference light reflected by the wafer 31 to be received by the first optical fiber 623. The first end 621 and the second end 631 are provided with small holes (e.g., about 0.5 mm in diameter) which are open on their side surfaces, and the light may enter and exit via the holes.

The light projector 62 includes a sheath tube 624 configured to accommodate the reflector 622 and a portion of the optical fiber 623, and a fixing part (or a first fixing holder) 625 configured to accommodate another portion of the optical fiber 623. The fixing part 625 is connected to the sheath tube 624 and is larger in diameter than the sheath tube 624. The light receiver 63 includes a sheath tube 634 (see FIG. 8) configured to accommodate the reflector 632 and a portion of the optical fiber 633, and a fixing part (or a second fixing holder) 635 (see FIG. 8) configured to accommodate another portion of the optical fiber 633. The fixing part 635 is connected to the sheath tube 634 and is larger in diameter than the sheath tube 634.

The sheath tubes 624 and 634 and the fixing parts 625 and 635 are, for example, metal tubes in which the optical fibers 623 and 633 are sealed with an adhesive. The fixing parts 625 and 635 are strong enough to withstand screwing. Large diameters of the fixing parts 625 and 635 make it easy for the fixing parts 625 and 635 to be fixed and positioned.

The partition 64 fits into a recess in the tip 611 of the support arm 61 and is fixed (screwed) by screws 614 and 615 (see FIG. 8). The partition 64 extends from the tip 611 toward the center of the wafer 31 placed on the end effector 37. In some embodiments, the partition 64 may be formed, for example, by black alumite treatment or black painting. For example, a reflectance in this case is about 0.1%. This makes it possible to reduce reflection of the reference light.

The partition 64 includes a plate 641 arranged below the light projector 62 and the light receiver 63, a wall 642 arranged between the light projector 62 and the light receiver 63, and a fixing part 643 fixed to the support arm 61. The plate 641 is configured to spread from a vicinity of the first end 621 to a vicinity of the second end 631 on an opposite side (herein, downward) of the wafer 31 to be detected when viewed from the light projector 62 and the light receiver 63. The wall 642 is installed on a surface of the plate 641 on the side of the wafer 31 to be detected, and prevents (blocks) the reference light from the first end 621 from being directly incident on the second end 631. Therefore, the wall 642 is formed with a predetermined height that is higher than heights of the axis of the light projector 62 and the axis of the light receiver 63. Further, the wall 642 is formed with a predetermined width.

The support arm 61 fixes positions of the first end 621 of the light projector 62 and the second end 631 of the light receiver 63 to the plate 641 or the wall 642. This allows an interval (sensor pitch) between the light projector 62b and the light receiver 63b to be optimized.

Actions of the plate 641 and the wall 642 and an arrangement range of the light receiver 63 will be described with reference to FIG. 4. FIG. 4 shows the arrangements of a plate 641a, a wall 642a, a light projector 62a, and a light receiver 63a in the uppermost stage of the substrate detector 60, and a plate 641b, a wall 642b, a light projector 62b, and a light receiver 63b in a stage below the uppermost stage. The arrangement range of the light receiver 63 when the position of the light projector 62 with respect to the wall 642 is fixed will be described.

In the uppermost stage, there is no plate 641 above a wafer 31a. Therefore, a reference light from the light projector 62a may be reflected by the wafer 31a and incident on the light receiver 63a. A portion of the reference light from the light projector 62a that exceeds the wall 642a may be incident on the light receiver 63a. The light receiver 63a may be arranged up to a position P3.

The plate 641a in the upper stage blocks a reference light from the light projector 62b in the lower stage. The wall 642a in the upper stage blocks direct incidence of the reference light from the light projector 62a on the light receiver 63a in the upper stage. The reference light from the light projector 62b in the lower stage is reflected by a bottom surface of a wafer 31b and a bottom surface of the plate 641a in the upper stage.

In the stage below the uppermost stage, for example, one stage below the uppermost stage, there is the plate 641a above the wafer 31b. Therefore, the reference light from the light projector 62b may be reflected by the plate 641a in addition to the wafer 31b and incident on the light receiver 63a.

It is assumed that Y is a distance (height) from the axes of the light projector 62b and light receiver 63b in the lower stage to the bottom surface of the wafer 31b located above the light projector 62b and the light receiver 63b. It is assumed that H is a distance (height) from the axes of the light projector 62b and the light receiver 63b to the bottom surface of the plate 641a in the upper stage. It is assumed that X is a distance from each of the axes of the light projector 62b and the light receiver 63b to each of side surfaces of the wall 642b in the lower stage. It is assumed that V is half a length (width) of the wall 642b in a direction perpendicular to the axis of the light projector 62b and the axis of the light receiver 63b, and h is a height from each of the axes of the light projector 62b and the light receiver 63b to a top surface of the wall 642b.

It is assumed that $\alpha$ is an angle at which the reference light from the light projector 62b exceeds the wall 642b, based on a line connecting the axes of the light projector 62b and the light receiver 63b. It is assumed that $\beta$ is an angle at which the reference light from the light projector 62b is reflected by the bottom surface of the wafer 31b and exceeds the wall 642b. It is assumed that $\theta$ is an angle at which the reference light from the light projector 62b is reflected by the bottom surface of the plate 641a in the upper stage above the center of the width of the wall 642b. Herein, a relationship among $\alpha$, $\beta$, and $\theta$ is as follows:

$$0 \text{ degrees} < \alpha < \beta < \theta < 90 \text{ degrees}$$

When it is assumed that A is a range in which the wafer 31b is detected but the plate 641a in the upper stage is not detected (an effective range: a distance between position P1 and position P2), then A is as follows:

$$Y/\tan\beta < A < H/\tan\theta$$

$$\tan\theta = Y/(X+V)$$

$$\tan\beta = h/(X-A)$$

$$\therefore YX/(Y+h) < A < H(X+V)/Y$$

Further, a distance between position P2 and position P3 is a range in which the wafer 3 1b and the plate 641a in the upper stage are detected, and a distance between position P3 and position P4 is a range in which the plate 641a in the upper stage is detected.

The light projected from the first end 621 spreads at a certain angle (the same applies to the light received). An aperture angle (half-value angle) representing the angle at which the light projected from the first end 621 spreads may be 2 to 60 degrees. A slightly wide aperture angle may be adopted so that an angle precision is not strict when the substrate detector 60 is assembled. Herein, denotation of a numerical range such as "2 to 60 degrees" means that a lower limit and an upper limit are included in that range. Thus, for example, "2 to 60 degrees" means "2 degrees or more and 60 degrees or less." The same applies to other numerical ranges.

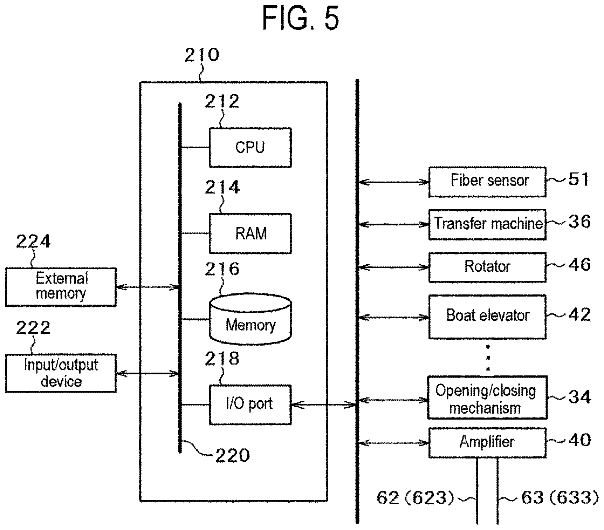

The light projector 62 and the light receiver 63 (base ends of a pair of optical fibers 623 and 633) are connected to an amplifier 40 (see FIG. 5). The amplifier 40 incorporates a light source (e.g., a light emitting diode), a light detector (e.g., a photodiode), and a detection circuit.

Light emitted from the light source incorporated in the amplifier 40 is incident on the base end of the optical fiber 623, propagates through the optical fiber 623, is incident on the reflector 622 from a tip face of the optical fiber 623, and emits from the first end 621. In a case where the emitted light (reference light) is reflected by the wafer 31 to be detected, the reflected light is incident on the second end 631 and is incident on a tip face of the optical fiber 633. Therefore, the light projector 62 and the light receiver 63 are fixed to the tip 611 of the support arm 61 so that an emission face (hole) of the first end 621 and an incidence face (hole) of the second end 631 face substantially the same direction. The incident light propagates through the optical fiber 633 and reaches the light detector incorporated in the amplifier 40.

The detection circuit incorporated in the amplifier 40 determines presence or absence of a substrate, including a transparent substrate, by threshold processing of a received light level. The threshold may be common to the substrate detectors. In other words, since risk of false detection is low, regulation for each substrate detector may not be performed.

As shown in FIG. 5, a controller 210, which is a control part (control means or unit), is constituted as a computer including a central processing unit (CPU) 212, a random access memory (RAM) 214, a memory 216, and an I/O port 218. The RAM 214, the memory 216, and the I/O port 218 are configured to be capable of exchanging data with the CPU 212 via an internal bus 220. An input/output device 222 constituted as, for example, a touch panel is connected to the controller 210.

The memory 216 is constituted by, for example, a flash memory, a hard disk drive (HDD), etc. A control program that controls operations of the substrate processing apparatus, a process recipe in which sequences and conditions of substrate processing, which will be described later, are written, etc. are readably stored in the memory 216. The process recipe functions as a program that is combined to cause the controller 210 to execute each sequence in a process of processing a substrate, which will be described later, to obtain a predetermined result. Hereinafter, the process recipe and the control program may be generally and simply referred to as a "program." When the term "program" is used herein, it may indicate a case of including the process recipe, a case of including the control program, or a case of including both the process recipe and the control program. The RAM 214 is constituted as a memory area (work area) in which programs or data read by the CPU 212 are temporarily stored.

The I/O port 218 is connected to the above-described transfer machine 36, rotator 46, boat elevator 42, amplifier 40, and the like.

The CPU 212 is configured to read and execute the control program from the memory 216 and also to read the process recipe from the memory 216 in response to an input of an operation command from the input/output device 222. The CPU 212 is configured to control a wafer transfer operation by the transfer machine 36, a rotation and a rotation speed adjustment operation of the boat 38 by the rotator 46, an elevating operation of the boat 38 by the boat elevator 42, and a substrate detection operation by the amplifier 40 in accordance with the contents of the read process recipe.

The controller 210 may be constituted by installing, on the computer, the aforementioned program stored in the external memory 224. The external memory 224 is, for example, a magnetic tape, a magnetic disk such as a flexible disk or a hard disk, an optical disc such as a CD or a DVD, a magneto-optical disc such as a MO, or a semiconductor memory such as a USB memory or a memory card. The memory 216 and the external memory 224 are constituted as a computer-readable recording medium. Hereinafter, the memory 216 and the external memory 224 may be generally referred to simply as a "recording medium." When the term "recording medium" is used herein, it may indicate a case of including the memory 216, a case of including the external memory 224, or a case of including both the memory 216 and the external memory 224. Furthermore, the program may be provided to the computer by using communication means or unit such as the Internet or a dedicated line, instead of using the external memory 224.

(2) Process of Processing Substrate

An overview of a process of processing a substrate by using the substrate processing apparatus 1 as a semiconductor manufacturing apparatus will be described below. Such a process of processing the substrate is, for example, a process of manufacturing a semiconductor device. In the following description, operation and processing of each component constituting the substrate processing apparatus 1 are controlled by the controller 210.

(Substrate Loading Step: S10)

When the pod 21 is supplied to the substrate processing apparatus 1, the pod 21 is transferred to the mounting stand 33.

An opening end surface of the pod 21 mounted on the mounting stand 33 is pressed against an opening edge of a wafer loading and unloading port 32 at the front wall 29 of the sub-housing 28, and the lid is removed by the opening/closing mechanism 34 to open the wafer entrance of the pod 21.

When the pod 21 is opened by the pod opener 26, the sensor rod 50 of the transfer machine 36 is moved to the protruding position (in a direction approaching the pod 21) by the advance and retreat driver 365. Then, the sensor rod 50 is moved up or down at a constant speed by the Z-axis direction driver 361, and the wafers 31 are mapped by the fiber sensor 51, thereby detecting the wafers 31 in the pod 21 in order. After the mapping operation is completed, the sensor rod 50 is returned to a retracted position.

Then, advance, ascent, and retreat of the end effector 37, turning and pitch change of the Y-axis rotation driver 362, advance, descent, and retreat of the end effector 37, and turning and pitch change of the Y-axis rotation driver 362 are repeated in sequence. As a result, the wafer 31 is picked up from the inside of the pod 21 via the wafer loading and unloading port 32 and is loaded (charged) into the boat 38. An output (state) of the substrate detector 60 when the end effector 37 is inserted into the pod 21 is stored. In a case where the output of the substrate detector 60 is monitored during the transfer and a change in the output is detected, such a change is determined as an abnormality, the transfer is stopped, and an alarm is issued. This makes it possible to detect a falling or a displacement of the substrate while being transferred.

After the loading is completed, the lower end of the process furnace 12, which is closed by the furnace opening shutter, is opened by the furnace opening shutter. Subsequently, as the seal cap 44 is moved up (boat up) by the boat elevator 42, the boat 38 holding the wafers 31 is loaded from the transfer chamber 35 into the process furnace 12.

(Film-Forming Step: S20)

After the loading, heat treatment is performed on the wafers 31 in the process chamber 14 inside the process furnace 12.

(Substrate Unloading Step: S30)

Next, the boat 38 on which the heat-treated wafers 31 are placed is unloaded from the process chamber 14 to the transfer chamber 35 (boat unloading). Then, the boat 38 cools the heat-treated wafers 31.

After the cooling, the sensor rod 50 of the transfer machine 36 is moved to the protruding position by the advance and retreat driver 365. Then, the sensor rod 50 is moved up or down by the Z-axis direction driver 361, and the fiber sensor 51 performs a mapping operation of the wafers 31. When the mapping is completed, the sensor rod 50 is returned to a storage position.

Subsequently, advance, ascent, and retreat of the end effector 37, turning and pitch change of the Y-axis rotation driver 362, advance, descent, and retreat of the end effector 37, and rotation and pitch change of the Y-axis rotation driver 362 are repeated in sequence. As a result, the wafer 31 is picked up from the inside of the boat 38 and is unloaded to the pod 21 via the wafer loading and unloading port 32. Thereafter, the pod 21 is unloaded to the outside of the housing 13. During this process, the output of the substrate detector 60 is monitored in the same manner as in the substrate loading step S10.

According to the embodiments of the present disclosure, one or more of the following effects are obtained.

(a) A height of the substrate detector may be reduced, making it possible to cope with transfer to a narrow-pitch boat.

(b) Reflected light (external disturbance light) from sources other than a target wafer may be reliably blocked, making it possible to improve a detection accuracy.

(c) Since the substrate detector is a reflective sensor in which the light projector is arranged so that an incidence angle is close to 90 degrees, a reflectance becomes high according to Fresnel's formula, making it possible to obtain a higher sensitivity (a higher S/N) than that in a transmission type sensor with an orthogonal optical axis or an oblique optical axis.

(d) It is possible to detect the wafer 31 even in a case where the wafer 31 is a visually transparent wafer (which transmits almost the entirety of visible light), for example, a silicon carbide (SiC) wafer.

(e) Even in a case where the pitch of the end effectors is changed, an optical arrangement such as a distance between the light projector and the light receiver does not change, making it possible to eliminate an influence on the operation of the sensor.

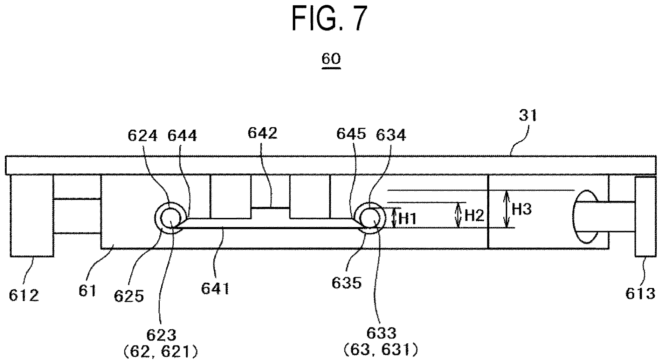

A substrate detector 60 in other embodiments of the present disclosure will be described with reference to FIGS. 7 and 8. FIG. 7 shows a state in which the substrate detector 60 is inserted between the wafers 31 placed on the pod 21 or the boat 38.

A configuration of the plate 641 of the partition 64 in these embodiments is different from that of the plate 641 in the embodiments shown in FIG. 4. Other configurations of the substrate detector 60 in these embodiments are the same as those in the embodiments shown in FIG. 4.

The width of the plate 641 is smaller than the distance between the central axis of the light projector 62 and the central axis of the light receiver 63. The ends of the plate 641 on both sides close to the first end 621 and the second end 631 respectively include first and second tapered surfaces 644 and 645 which are pointed toward points (lower ends) of the first end 621 and the second end 631 which are farthest from the corresponding wafer 31 (wafer 31 to be detected). This makes it possible to prevent incidence of the reference light from the lower stage. The tapered surfaces 644 and 645 are formed, for example, by performing a chamfering at 30 degrees with respect to a horizontal plane. The points (lower ends) of the first end 621 and the second end 631 which are farthest from the corresponding wafer 31 are arranged on substantially the same plane as the surface of the plate 641 on an opposite side of the corresponding wafer 31 (the bottom surface of the plate 641). The bottom surface of the plate 641 is arranged on approximately the same plane as the bottom surface of the corresponding end effector 37.

A maximum thickness of the portion (tip) of the substrate detector 60 which is inserted between the wafers, i.e., a sum of the heights of the plate 641 and the wall 642, is substantially the same as outer diameter of the sheath tubes 624 and 634 and is designated as H1. When the wafer 31 is placed on the end effector 37, the end effector 37 and the substrate detector 60 rise toward the wafer 31. A distance (wafer placement height) between the bottom end of the substrate detector 60 and the bottom surface of the wafer 31 at this time is designated as H2. Further, a maximum thickness (height) of a portion of the end effector 37 which is inserted between the wafers is designated as H3. Herein, H1 < H2 < H3. H1 is, for example, 0.5 mm to 2 mm, H2 is, for example, 1 mm to 3 mm or H1+0.2 mm to H1+1.5 mm, and H3 is, for example, 11.3 mm to 4 mm or H2+0.3 mm to H2+2 mm.

In these embodiments, the same effects as the above-described embodiments may be obtained. Further, a position of the bottom surface of the plate 641 in these embodiments is closer to the light projector 62 and the light receiver 63 than the position of the bottom surface of the plate 641 in the embodiments shown in FIG. 4. As a result, the portion (tip) of the substrate detector 60 which is inserted between the wafers becomes thinner. This makes it possible to make the upper end of the tip of the substrate detector 60 lower than the bottom surface of the wafer 31, thereby avoiding contact with the wafer 31. Further, a height of the lower end of the tip of the substrate detector 60 may be equal to or higher than a height of the lower end of the end effector 37, thereby avoiding a reduction in transfer clearance.

Though the embodiments of the present disclosure are specifically described above, the present disclosure is not limited to the above-described embodiments but may be modified in various ways without departing from the spirit of the present disclosure. For example, a groove may be formed, along a radial direction of the wafer, on the bottom surface of the plate 641 directly below the wall 642, thereby further reducing a rear surface reflection of the plate 641.

Examples of performing the heat treatment by using a batch-type substrate processing apparatus configured to process a plurality of substrates at a time are described in the above-described embodiments. The present disclosure is not limited to the above-described embodiments, but may also be suitably applied to a case where the heat treatment is performed by using, for example, a single-wafer substrate processing apparatus configured to process one or several substrates at a time. In addition, examples in which a film is formed by using a substrate processing apparatus including a hot-wall-type process furnace are described in the above-described embodiments. The present disclosure is not limited to the above-described embodiments, but may also be suitably applied to a case where the heat treatment is performed by using a substrate processing apparatus including a cold-wall-type process furnace.

Even when such substrate processing apparatuses are used, each process may be performed by using the same processing sequences and process conditions as the above-described embodiments, and the same effects as the above-described embodiments may be obtained.

According to the present disclosure in some embodiments, it is possible to detect a substrate even in a case where the substrate is transparent.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1. A transfer machine (36) comprising:

    (a) at least one end effector (37) configured to be capable of being inserted into a holder (21) configured to accommodate a plurality of substrates in multiple stages without being in contact with the plurality of substrates, and gripping a corresponding substrate of the plurality of substrates respectively; and
    (b) at least one substrate detector (60) arranged at a predetermined relative position with respect to the at least one end effector (37) and configured to be capable of optically detecting the corresponding substrate in at least one selected from the group of a state in which the at least one end effector (37) is inserted into the holder (21) and a state in which the at least one end effector (37) grips the corresponding substrate, the at least one substrate detector (60) including:

        (b 1) a light projector (62, 62a, 62b) formed in a rod-shape and including a first end (621) configured to emit a reference light from a first optical fiber (623);
        (b2) a light receiver (63, 63a, 63b) formed in a rod-shape and including a second end (631) which substantially faces the first end (621) and is configured to receive the reference light reflected by a rear surface or a front surface of the corresponding substrate, which is transparent, and guide the reference light thus received to a second optical fiber (633);
        (b3) a plate (641, 641a, 641b) extending from a vicinity of the first end (621) to a vicinity of the second end (631) on an opposite side of the corresponding substrate when viewed from the light projector (62, 62a, 62b) and the light receiver (63, 63a, 63b); and
        (b4) a wall (642, 642a, 642b) configured to prevent the reference light from being directly incident from the first end (621) on the second end (631).

2. The transfer machine (36) of Claim 1, wherein the light projector (62, 62a, 62b) and the light receiver (63, 63a, 63b) are arranged in substantially parallel to each other, and a width of the plate (641, 641a, 641b) is smaller than a distance between a central axis of the light projector (62, 62a, 62b) and a central axis of the light receiver (63, 63a, 63b).

3. The transfer machine (36) of Claim 1 or 2, wherein ends of the plate (641, 641a, 641b) on both sides close to the first end (621) and the second end (631) respectively include a first tapered surface (644) and a second tapered surface (645) which are pointed toward points of the first end (621) and the second end (631) which are farthest from the corresponding substrate.

4. The transfer machine (36) of any one of Claims 1 to 3, wherein the plate (641, 641a, 641b) is arranged in substantially parallel to the corresponding substrate gripped by the at least one end effector (37), and points of the first end (621) and the second end (631) which are farthest from the corresponding substrate are arranged on substantially the same plane as a surface of the plate (641, 641a, 641b) on an opposite side of the corresponding substrate.

5. The transfer machine (36) of Claim 1, wherein the at least one end effector (37) includes a plurality of end effectors (37),

    wherein the plurality of end effectors (37) are installed in a direction perpendicular to surfaces of corresponding substrates of the plurality of substrates gripped by the plurality of end effectors (37) respectively,
    wherein the at least one substrate detector (60) includes a plurality of substrate detectors (60), and
    wherein each of the plurality of substrate detectors (60) is installed to be separate from each of the plurality of end effectors (37) for each of the plurality of end effectors (37).

**6.** The transfer machine (36) of Claim 5, further comprising a pitch variator configured to be capable of changing a gap between end effectors (37) of the plurality of end effectors (37).

**7.** The transfer machine (36) of any one of Claims 1 to 6, wherein each of the plurality of substrate detectors (60) further includes a support arm (61) configured to fix and hold positions of the first end (621) and the second end (631) with respect to the plate (641, 641a, 641b) or the wall (642, 642a, 642b).

**8.** The transfer machine (36) of Claim 5 or 6, wherein the first end (621) includes a first reflector (622) configured to reflect the reference light from the first optical fiber (623) in a direction perpendicular to a longitudinal direction of the light projector (62, 62a, 62b), and
wherein the second end (631) includes a second reflector (632) configured to reflect the reference light from a direction perpendicular to a longitudinal direction of the light receiver (63, 63a, 63b) and guide the reference light thus reflected to the second optical fiber (633).

**9.** The transfer machine (36) of any one of Claims 5, 6, and 8, wherein the light projector (62, 62a, 62b) includes a first sheath tube (624) configured to accommodate a portion of the first optical fiber (623) and the first end (621), and a first fixing holder (625) configured to be connected to the first sheath tube (624), accommodate another portion of the first optical fiber (623), and be larger in diameter than the first sheath tube (624), and
wherein the light receiver (63, 63a, 63b) includes a second sheath tube (634) configured to accommodate a portion of the second optical fiber (633) and the second end (631), and a second fixing holder (635) configured to be connected to the second sheath tube (634), accommodate another portion of the second optical fiber (633), and be larger in diameter than the second sheath tube (634).

**10.** The transfer machine (36) of any one of Claims 1 to 4, wherein the light projector (62, 62a, 62b) and the light receiver (63, 63a, 63b) are arranged in substantially parallel to each other, and a longitudinal direction of the light projector (62, 62a, 62b) or the light receiver (63, 63a, 63b) is substantially consistent with a radial direction of each of the corresponding substrates,

wherein the light projector (62, 62a, 62b) includes a first sheath tube (624) configured to accommodate a portion of the first optical fiber (623) and the first end (621), and a first fixing holder (625) configured to be connected to the first sheath tube (624), accommodate another portion of the first optical fiber (623), and be larger in diameter than the first sheath tube (624), and
wherein the light receiver (63, 63a, 63b) includes a second sheath tube (634) configured to accommodate a portion of the second optical fiber (633) and the second end (631), and a second fixing holder (635) configured to be connected to the second sheath tube (634), accommodate another portion of the second optical fiber (633), and be larger in diameter than the second sheath tube (634).

**11.** A substrate processing apparatus (1) comprising:

(a) at least one end effector (37) configured to be capable of being inserted into a holder (21) configured to accommodate a plurality of substrates in multiple stages without being in contact with the plurality of substrates, and gripping a corresponding substrate of the plurality of substrates respectively; and
(b) at least one substrate detector (60) arranged at a predetermined relative position with respect to the at least one end effector (37) and configured to be capable of optically detecting the corresponding substrate in at least one selected from the group of a state in which the at least one end effector (37) is inserted into the holder (21) and a state in which the at least one end effector (37) grips the corresponding substrate, the at least one substrate detector (60) including:

(b1) a light projector (62, 62a, 62b) formed in a rod-shape and including a first end (621) configured to emit a reference light from a first optical fiber (623);
(b2) a light receiver (63, 63a, 63b) formed in a rod-shape and including a second end (631) which substantially faces the first end (621) and is configured to receive the reference light reflected by a rear surface or a front surface of the corresponding substrate, which is transparent, and guide the reference light thus received to a second optical fiber (633);
(b3) a plate (641, 641a, 641b) extending from a vicinity of the first end (621) to a vicinity of the second end (631) on an opposite side of the corresponding substrate when viewed from the light projector (62, 62a, 62b) and the light receiver (63, 63a, 63b); and
(b4) a wall (642, 642a, 642b) configured to prevent the reference light from being directly incident from the first end (621) on the second end (631).

**12.** A method of processing a substrate, comprising:

transferring the substrate by using a transfer machine (36) including:

(a) at least one end effector (37) configured to be capable of being inserted into a holder (21) configured to accommodate a plurality of substrates including the substrate in multiple stages without being in contact with the plurality of substrates, and gripping a corresponding substrate of the plurality of substrates respectively; and
(b) at least one substrate detector (60) arranged at a predetermined relative position with respect to the at least one end effector (37) and configured to be capable of optically detecting the corresponding substrate in at least one selected from the group of a state in which the at least one end effector (37) is inserted into the holder (21) and a state in which the at least one end effector (37) grips the corresponding substrate, the at least one substrate detector (60) including:

(b 1) a light projector (62, 62a, 62b) formed in a rod-shape and including a first end (621) configured to emit a reference light from a first optical fiber (623);
(b2) a light receiver (63, 63a, 63b) formed in a rod-shape and including a second end (631) which substantially faces the first end and is configured to receive the reference light reflected by a rear surface or a front surface of the corresponding substrate, which is transparent, and guide the reference light thus received to a second optical fiber (633);
(b3) a plate (641, 641a, 641b) extending from a vicinity of the first end to a vicinity of the second end (631) on an opposite side of the corresponding substrate when viewed from the light projector (62, 62a, 62b) and the light receiver (63, 63a, 63b); and
(b4) a wall (642, 642a, 642b) configured to prevent the reference light from being directly incident from the first end (621) on the second end (631); and

processing the substrate.

13. The method of Claim 12, wherein in the act of transferring the substrate, an output of the at least one substrate detector (60) is monitored to detect a falling or a displacement of the substrate while the substrate is being transferred.

14. A method of manufacturing a semiconductor device, comprising the method of Claim 12.

15. A program that causes, by a computer, a substrate processing apparatus (1) to perform a process comprising:

transferring a substrate by using a transfer machine (36) including:

(a) at least one end effector (37) configured to be capable of being inserted into a holder (21) configured to accommodate a plurality of substrates including the substrate in multiple stages without being in contact with the plurality of substrates, and gripping a corresponding substrate of the plurality of substrates respectively; and
(b) at least one substrate detector (60) arranged at a predetermined relative position with respect to the at least one end effector (37) and configured to be capable of optically detecting the corresponding substrate in at least one selected from the group of a state in which the at least one end effector (37) is inserted into the holder (21) and a state in which the at least one end effector (37) grips the corresponding substrate, the at least one substrate detector (60) including:

(b1) a light projector (62, 62a, 62b) formed in a rod-shape and including a first end (621) configured to emit a reference light from a first optical fiber (623);
(b2) a light receiver (63, 63a, 63b) formed in a rod-shape and including a second end (631) which substantially faces the first end (621) and is configured to receive the reference light reflected by a rear surface or a front surface of the corresponding substrate, which is transparent, and guide the reference light thus received to a second optical fiber (633);
(b3) a plate (641, 641a, 641b) extending from a vicinity of the first end (621) to a vicinity of the second end (631) on an opposite side of the corresponding substrate when viewed from the light projector (62, 62a, 62b) and the light receiver (63, 63a, 63b); and
(b4) a wall (642, 642a, 642b) configured to prevent the reference light from being directly incident from the first end (621) on the second end (631); and

processing the substrate.

# FIG. 1

# FIG. 2

# FIG. 3

# FIG. 4

<u>60</u>

# FIG. 5

FIG. 6

```
        ┌─────────────┐
        │    Start    │
        └──────┬──────┘
               │
               ▼
   ┌───────────────────────┐
   │   Loading substrate   │──~S10
   └───────────┬───────────┘
               │
               ▼
   ┌───────────────────────┐
   │      Forming film     │──~S20
   └───────────┬───────────┘
               │
               ▼
   ┌───────────────────────┐
   │  Unloading substrate  │──~S30
   └───────────┬───────────┘
               │
               ▼
        ┌─────────────┐
        │     End     │
        └─────────────┘
```

# FIG. 7

<u>60</u>

# FIG. 8

60

# EUROPEAN SEARCH REPORT

Europäisches
Patentamt
European
Patent Office
Office européen
des brevets

**Application Number**

EP 24 19 6611

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/328340 A1 (SONG BYOUNG GYU [KR] ET AL) 13 October 2022 (2022-10-13) * abstract; figures 1, 2, 5, 7 * * paragraphs [0044], [0053] - [0056] * | 1-15 | INV. H01L21/67 H01L21/677 H01L21/687 |
| A | WO 2020/137991 A1 (KAWASAKI HEAVY IND LTD [JP]; KAWASAKI ROBOTICS USA INC [US]) 2 July 2020 (2020-07-02) * abstract; figures 6-8, 10 * | 1-15 | |
| A | US 2020/411348 A1 (YOSHIDA MASAYA [JP] ET AL) 31 December 2020 (2020-12-31) * abstract; figures 1, 2, 5 * * paragraphs [0036], [0037], [0040], [0053] * | 1-15 | |
| A | US 2005/110287 A1 (FLORINDI ANTHONY [US] ET AL) 26 May 2005 (2005-05-26) * abstract; figures 3-6, 9a, 9b * * paragraphs [0036], [0037], [0042], [0046] * | 1-15 | TECHNICAL FIELDS SEARCHED (IPC) |
| A | US 7 235 806 B2 (ASM INC [US]) 26 June 2007 (2007-06-26) * abstract; claim 4; figures 3-7 * * column 4, line 36 - column 5, line 27 * | 1-15 | H01L |

The present search report has been drawn up for all claims

| Place of search | Date of completion of the search | Examiner |
|---|---|---|
| The Hague | 24 February 2025 | Faderl, Ingo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 6611

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2025

| Patent document cited in search report | Publication date | Patent family member(s) | Publication date |
|---|---|---|---|
| US 2022328340 A1 | 13-10-2022 | CN 115206855 A | 18-10-2022 |
| | | JP 7389166 B2 | 29-11-2023 |
| | | JP 2022162541 A | 24-10-2022 |
| | | KR 20220141111 A | 19-10-2022 |
| | | TW 202240751 A | 16-10-2022 |
| | | US 2022328340 A1 | 13-10-2022 |
| WO 2020137991 A1 | 02-07-2020 | CN 113228246 A | 06-08-2021 |
| | | JP 7045484 B2 | 31-03-2022 |
| | | JP WO2020137991 A1 | 27-09-2021 |
| | | KR 20210100684 A | 17-08-2021 |
| | | TW 202025362 A | 01-07-2020 |
| | | US 2020206917 A1 | 02-07-2020 |
| | | WO 2020137991 A1 | 02-07-2020 |
| US 2020411348 A1 | 31-12-2020 | CN 114008745 A | 01-02-2022 |
| | | JP 7266714 B2 | 28-04-2023 |
| | | JP 2022531326 A | 06-07-2022 |
| | | KR 20220025019 A | 03-03-2022 |
| | | TW 202103254 A | 16-01-2021 |
| | | US 2020411348 A1 | 31-12-2020 |
| | | WO 2020263357 A1 | 30-12-2020 |
| US 2005110287 A1 | 26-05-2005 | DE 102004051841 A1 | 11-08-2005 |
| | | JP 2005167208 A | 23-06-2005 |
| | | US 2005110287 A1 | 26-05-2005 |
| US 7235806 B2 | 26-06-2007 | US 2004227111 A1 | 18-11-2004 |
| | | US 2007242281 A1 | 18-10-2007 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024050710 A